# EUROPÄISCHE PATENTSCHRIFT

(11) **EP 1 929 547 B1**
(45) Veröffentlichungstag und Bekanntmachung des Hinweises auf die Patenterteilung: **02.12.2009**
(21) Anmeldenummer: 06791396.2
(22) Anmeldetag: 22.09.2006
(51) Int. Cl.: H01L 33/00

(54) **ELEKTROMAGNETISCHE STRAHLUNG EMITTIERENDES OPTOELEKTRONISCHES BAUELEMENT UND VERFAHREN ZUR HERSTELLUNG EINES OPTOELEKTRONISCHEN BAUELEMENTS**
OPTOELECTRONIC COMPONENT WHICH EMITS ELECTROMAGNETIC RADIATION, AND METHOD FOR PRODUCTION OF AN OPTOELECTRONIC COMPONENT
COMPOSANT OPTOELECTRONIQUE EMETTANT UN RAYONNEMENT ELECTROMAGNETIQUE ET PROCEDE DE REALISATION D'UN COMPOSANT OPTOELECTRONIQUE

(30) Priorität: 30.09.2005 DE 102005047062; 31.01.2006 DE 102006004397
(43) Veröffentlichungstag der Anmeldung: 11.06.2008
(73) Patentinhaber: OSRAM Opto Semiconductors GmbH, 93055 Regensburg (DE)
(72) Erfinder: BRUNNER, Herbert, 93161 Sinzing (DE); PETERSEN, Kirstin, 93059 Regensburg (DE)
(74) Vertreter: Epping - Hermann - Fischer
(86) Internationale Anmeldenummer: PCT/DE2006/001686
(87) Internationale Veröffentlichungsnummer: WO 2007/036206

(56) Entgegenhaltungen:
- EP-A2- 1 193 772
- EP-A2- 1 408 559
- DE-A1- 10 361 661
- JP-A- 2003 046 140
- US-A- 5 137 844
- US-B1- 6 613 247

## Beschreibung

Gegenstand der vorliegenden Erfindung ist ein optoelektronisches Bauelement gemäß dem Oberbegriff von Anspruch 1 sowie ein Verfahren zum Herstellen eines derartigen optoelektronischen Bauelements.

Ein Licht emittierendes optoelektronisches Bauelement ist beispielsweise in der US 5,040,868 offenbart. Es weist einen Gehäusegrundkörper auf, der zwei elektrische Leiterbahnen eines Leiterrahmens umformt sowie eine Ausnehmung aufweist, in der ein elektromagnetische Strahlung emittierender Lumineszenzdiodenchip elektrisch leitend und mechanisch montiert ist. Die Ausnehmung ist mit einer strahlungsdurchlässigen Gussmasse vergossen, durch die eine Auskopplung elektromagnetischer Strahlung aus dem Lumineszenzdiodenchip verbessert wird und der Lumineszenzdiodenchip vor äußeren Einflüssen geschützt ist.

Lumineszenzdiodenchips, die in derartigen Bauelementen verwendet werden, unterliegen bei ihrer Herstellung gewissen Fertigungsschwankungen, die häufig zu Schwankungen in der Helligkeit von nominal gleichartigen Halbleiterchips bei deren Betrieb führen. Sowohl die in unterschiedlichen Epitaxie-Prozessläufen hergestellten Wafer, als auch die gleichzeitig in einem Prozesslauf hergestellten verschiedenen Wafer unterliegen derartigen Fertigungsschwankungen, die insbesondere Schwankungen bei Epitaxieprozessen und Dotierprozessen umfassen.

Es ist eine Aufgabe der vorliegenden Erfindung, ein optoelektronisches Bauelement der eingangs genannten Art bereitzustellen, das auf technisch einfache Weise mit einer vorgegebenen Strahlstärke oder Lichtstärke herstellbar ist. Zudem soll ein Verfahren zum Herstellen derartiger optoelektronischer Bauelemente angegeben werden.

Diese Aufgabe wird durch ein optoelektronisches Bauelement oder ein Verfahren gemäß der unabhängigen Patentansprüche gelöst. Vorteilhafte Ausführungsformen und bevorzugte Weiterbildungen des Bauelementes und des Verfahrens sind Gegenstand der abhängigen Patentansprüche.

Es wird ein optoelektronisches Bauelement mit einem Gehäuse und einem in dem Gehäuse angeordneten Lumineszenzdiodenchip angegeben, das eine elektromagnetische Nutzstrahlung emittiert. Das Gehäuse weist ein für die Nutzstrahlung durchlässiges Gehäusematerial auf. Dieses Gehäusematerial ist zum Einstellen einer vorgegebenen Strahlstärke oder Lichtstärke der emittierten Nutzstrahlung gezielt mit strahlungsabsorbierenden Partikeln versetzt.

Das Wellenlängenspektrum der Nutzstrahlung umfasst bevorzugt einen für das menschliche Auge sichtbaren Bereich. Entsprechend ist durch die strahlungsabsorbierenden Partikel bevorzugt die Lichtstärke eines von dem optoelektronischen Bauelement emittierten Nutzlichtes eingestellt.

Unter dem Begriff "strahlungsabsorbierende Partikel" sind im Zusammenhang mit der vorliegenden Anmeldung keine Leuchtstoffe zu verstehen, die für eine von dem Lumineszenzdiodenchip emittierte Strahlung eines ersten Wellenlängenbereiches absorbierend sind und durch diese Strahlung angeregt werden, um eine elektromagnetische Strahlung eines zweiten Wellenlängenbereiches zu emittieren, der sich vom ersten Wellenlängenbereich unterscheidet. Mit anderen Worten reemittieren die strahlungsabsorbierenden Partikel keine optische Strahlung, wenn sie eine elektromagnetische Nutzstrahlung des Bauelements absorbiert haben. Es ist dagegen möglich, dass die strahlungsabsorbierenden Partikel die Nutzstrahlung nicht nur absorbieren, sondern zum Teil auch streuen.

Durch die strahlungsabsorbierenden Partikel wird die beim Betrieb des optoelektronischen Bauelements emittierte Strahlstärke oder Lichtstärke auf technisch einfache Weise gezielt verringert. Es wird somit eine Verringerung der Effizienz des optoelektronischen Bauelements in Kauf genommen, um dessen Strahlstärke oder Lichtstärke unabhängig von schwankenden Strahlstärken oder Lichtstärken der verwendeten Lumineszenzdiodenchips präzise einzustellen.

Es wird zudem ein Verfahren zum Herstellen eines optoelektronischen Bauelements angegeben, bei dem ein Lumineszenzdiodenchip bereitgestellt wird. Die von dem Lumineszenzdiodenchip bei dessen Betrieb emittierte Strahlstärke oder Lichtstärke wird gemessen. Bei einer bereitzustellenden Masse, die für die Nutzstrahlung durchlässig ist sowie mit strahlungsabsorbierenden Partikeln versetzt ist, wird die Konzentration der strahlungsabsorbierenden Partikel gezielt in Abhängigkeit der gemessenen Strahlstärke oder Lichtstärke ausgewählt, um dadurch mittelbar eine zu erzielende Strahlstärke oder Lichtstärke des Bauelements einzustellen. In einem weiteren Verfahrensschritt wird die für die Nutzstrahlung durchlässige Masse in einem Strahlengang der von dem Lumineszenzdiodenchip bei dessen Betrieb emittierten elektromagnetischen Strahlung angeordnet.

Die Masse ist zweckmäßigerweise eine härtbare Masse, in die die strahlungsabsorbierenden Partikel im ungehärteten Zustand eingemischt werden. Das Einstellen einer zu erzielenden Helligkeit, das heißt einer Strahlstärke oder Lichtstärke des Bauelements, erfordert mit dem angegebenen Verfahren das Messen der von dem Lumineszenzdiodenchip emittierten Strahlstärke oder Lichtstärke sowie ein Auswählen der Konzentration der strahlungsabsorbierenden Partikel in Abhängigkeit des Niessergebnisses. Dies ist auf technisch einfache Weise durchführbar und ermöglicht ein sehr präzises Einstellen der Helligkeit.

Die strahlungsabsorbierenden Partikel sind mit Vorteil für das gesamte Wellenlängenspektrum der Nutzstrahlung absorbierend. Zusätzlich oder alternativ sind sie vorteilhafterweise für das gesamte Wellenlängenspektrum der von dem Lumineszenzdiodenchip bei dessen Betrieb emittierten Strahlung absorbierend. Besonders bevorzugt variiert der Absorptionskoeffizient der strahlungsabsorbierenden Partikel im gesamten Spektrum der Nutzstrahlung um weniger als 10 %. Insbesondere weisen die Partikel im relevanten Wellenlängenbereich eine vernachlässigbar große Wellenlängenabhängigkeit in der Absorption auf. Dadurch kann die Helligkeit des Bauelementes verringert werden, ohne das Emissionsspektrum der Nutzstrahlung signifikant zu beeinflussen.

Gemäß einer weiteren vorteilhaften Ausführungsform des Bauelements weist das für die Nutzstrahlung durchlässige Gehäusematerial mindestens einen Leuchtstoff auf. Es wurde festgestellt, dass auch in diesem Fall ein präzises Einstellen der Helligkeit mittels der strahlungsabsorbierenden Partikel möglich ist.

Die strahlungsabsorbierenden Partikel weisen Ruß auf. Ruß ist allgemein als Nebenprodukt bei Verbrennungsprozessen bekannt. Zudem wird er industriell produziert und als Farbstoff, insbesondere als verstärkender Füllstoff in Autoreifen verwendet. Ruß weist in der Regel eine relativ starke Wellenlängenabhängigkeit in seinem Absorptionsverhalten auf, was insbesondere auch für sichtbares Licht gilt. Es wurde jedoch festgestellt, dass bestimmte Formen von Ruß im sichtbaren Wellenlängenbereich eine sehr geringe Wellenlängenabhängigkeit im Absorptionsverhalten aufweisen.

Industrieruß wird mit verschiedenen definierten technischen Eigenschaften produziert. Ruß liegt in Form von Aggregaten vor, die sich aus einer Mehrzahl von Primärpartikeln zusammensetzen. Für eine Verwendung als strahlungsabsorbierende Partikel eignet sich insbesondere Ruß mit besonders kleinen Primärpartikelgrößen. Zudem ist es vorteilhaft, Industrieruß mit kompakter Aggregatstruktur zu verwenden. Für derartige Rußarten wird in Fachkreisen der englische Ausdruck "low structure carbon black" (LSCB) verwendet. Die Aggregate weisen bevorzugt eine durchschnittliche Ausdehnung von kleiner als oder gleich 1 µm auf.

Die strahlungsabsorbierenden Partikel sind gemäß einer zweckmäßigen Ausführungsform des Bauelements elektrisch isolierend. Damit ist es möglich, dass das für die Nutzstrahlung durchlässige Gehäusematerial unmittelbar an den Lumineszenzdiodenchip angrenzt, ohne dass die Gefahr einer Kurzschlussbildung auf Grund elektrisch leitender Partikel besteht. Es können alternativ auch elektrisch leitende Partikel verwendet werden. Wenn die Konzentration von diesen im Gehäusematerial ausreichend gering ist, kann das Risiko einer Kurzschlussbildung ebenfalls zumindest weitgehend vermieden werden. Die maximale Konzentration hängt dabei von der Aggregatgröße ab. Mit LSCB, das eine, verglichen mit gewöhnlichen Rußpartikeln, geringe Aggregatgröße aufweist, kann eine höhere Konzentration bei gleichem Risiko für eine Kurzschlussbildung verwendet werden.

Allgemein weisen die strahlungsabsorbierenden Partikel mit Vorteil einen mittleren Partikeldurchmesser von kleiner als oder gleich 100 nm auf (Teilchenmittel). Derart kleine Partikel lassen sich besonders gut in einem Gehäusematerial dispergieren. Im Fall von Ruß weisen die Primärpartikel der Agglomerate bevorzugt einen derart geringen mittleren Partikeldurchmesser auf.

Das für die Nutzstrahlung durchlässige Gehäusematerial weist bevorzugt eine Gussmasse oder eine Pressmasse auf. Mit derartigen Materialien lassen sich Gehäuseteile von wohldefinierten Formen und Ausmessungen herstellen. Gussmassen lassen sich vergießen oder beispielsweise in einem Spritzgussverfahren formen. Pressmassen können in einem Spritzpressverfahren verarbeitet werden.

In einer zweckmäßigen Ausführungsform weist das für die Nutzstrahlung durchlässige Gehäusematerial mindestens eines der Materialien aus der Gruppe bestehend aus Epoxydharz, Acrylat, Silikon, Thermoplast und Hybridmaterial mit mindestens einem dieser Materialien auf.

In einer weiteren bevorzugten Ausführungsform ist der Lumineszenzdiodenchip mittels des für die Nutzstrahlung durchlässigen Gehäusematerials umkapselt oder umformt. Insbesondere ist es möglich, dass das Gehäusematerial unmittelbar an den Lumineszenzdiodenchip angrenzt.

In einer zweckmäßigen Ausführungsform weist, das Bauelement einen Gehäusegrundkörper mit einer Gehäusekavität auf, in der der Lumineszenzdiodenchip montiert ist. Die Gehäusekavität ist zumindest teilweise mit dem für die Nutzstrahlung durchlässigen Gehäusematerial gefüllt. Das Füllen der Gehäusekavität erfolgt bevorzugt durch Vergießen mit der für die Nutzstrahlung durchlässigen Masse.

Eine weitere vorteilhafte Ausführungsform des Bauelements sieht vor, dass das Bauelement einen Gehäusekörper mit einer Außenfläche aufweist. Das für die Nutzstrahlung durchlässige Gehäusematerial ist zumindest auf die Außenfläche des Gehäusekörpers aufgebracht.

Zweckmäßigerweise kann das auf der Außenfläche des Gehäusekörpers aufgebrachte Gehäusematerial in Form einer Folie vorliegen. Diese ist beispielsweise durch Auflaminieren oder mittels eines Klebstoffes auf der Außenfläche des Gehäusekörpers befestigt. Die Folie weist mit Vorteil eine konstante Dicke auf. Sie ist zweckmäßigerweise flexibel ausgeführt. Alternativ ist es auch möglich, dass die Dicke der Folie variiert. Dies lässt sich beispielsweise bewerkstelligen, in dem eine Folie mit konstanter Dicke gezielt strukturiert wird.

Zusätzlich oder alternativ ist es auch möglich, eine Folie als Gehäusematerial zu verwenden, die mit strahlungsabsorbierenden Partikeln versetzt ist.

Es wird ein Lumineszenzdiodenchip angegeben, dessen Außenfläche mit einem Deckmaterial versehen ist, das zum Einstellen einer vorgegebenen Strahlstärke oder Lichtstärke einer vom Lumineszenzdiodenchip emittierten Nutzstrahlung gezielt mit strahlungsabsorbierenden Partikeln versetzt ist. Das Deckmaterial ist bevorzugt unmittelbar auf dem Lumineszenzdiodenchip aufgebracht. Besonders bevorzugt liegt das Deckmaterial in Form einer Folie vor. Die Folie ist beispielsweise durch Auflaminieren oder mittels eines Klebstoffes auf der Außenfläche des Lumineszenzdiodenchips befestigt. Dies kann noch im Waferverbund erfolgen, d.h. bevor eine Vielzahl von Lumineszenzdiodenchips aus einem gemeinsamen Verbund vereinzelt werden.

Weitere Vorteile, bevorzugte Ausführungsformen und Weiterbildungen des Bauelements und des Verfahrens ergeben sich aus den im Folgenden in Verbindung mit den Figuren 1 bis 12 erläuterten Ausführungsbeispielen. Es zeigen:
- Figur 1: eine schematische Schnittansicht eines ersten Ausführungsbeispiels des optoelektronischen Bauelements,
- Figur 2: eine schematische Schnittansicht eines zweiten Ausführungsbeispiels des optoelektronischen Bauelements,
- Figur 3: eine schematische Schnittansicht eines dritten Ausführungsbeispiels des optoelektronischen Bauelements,
- Figur 4: eine grafische Auftragung von Wellenlängen der Emissionsmaxima von Bauelementen mit verschiedenen Lumineszenzdiodenchips in Abhängigkeit der Konzentration strahlungsabsorbierender Partikel,
- Figur 5: eine grafische Auftragung der normierten Lichtstärke von Bauelementen mit verschiedenen Lumineszenzdiodenchips in Abhängigkeit der Konzentration von strahlungsabsorbierenden Partikeln,
- Figur 6: eine grafische Darstellung des normierten Lichtstromes von Bauelementen mit unterschiedlichen Lumineszenzdiodenchips in Abhängigkeit der Konzentration von strahlungsabsorbierenden Partikeln,
- Figur 7: eine grafische Darstellung der normierten Leuchtdichte eines Bauelements in Abhängigkeit des resultierenden x-Wertes der CIE-Farbtafel und für unterschiedliche Konzentrationen eines Leuchtstoffs in dem mit strahlungsabsorbierenden Partikeln versetzten Gehäusematerial,

- Figur 8: eine grafische Darstellung des normierten Leuchtstroms eines Bauelements in Abhängigkeit des resultierenden x-Wertes der CIE-Farbtafel und für unterschiedliche Konzentrationen eines Leuchtstoffs in dem mit strahlungsabsorbierenden Partikeln versetzten Gehäusematerial,
- Figur 9: eine grafische Darstellung der normierten Lichtstärke eines Bauelements mit einem Leuchtstoff in dem mit den strahlungsabsorbierenden Partikeln versetzten Gehäusematerial in Abhängigkeit der Konzentration der strahlungsabsorbierenden Partikel,
- Figur 10: eine grafische Darstellung des normierten Lichtstroms eines Bauelements mit einem Leuchtstoff in dem mit den strahlungsabsorbierenden Partikeln versetzten Gehäusematerial in Abhängigkeit der Konzentration der strahlungsabsorbierenden Partikel,
- Figur 11: eine schematische Schnittansicht eines vierten Ausführungsbeispiels des optoelektronischen Bauelements, und
- Figur 12: eine schematische Schnittansicht eines fünften Ausführungsbeispiels des optoelektronischen Bauelements.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht notwendigerweise als maßstabsgerecht anzusehen. Vielmehr sind einige Details der Figuren zum besseren Verständnis übertrieben groß dargestellt.

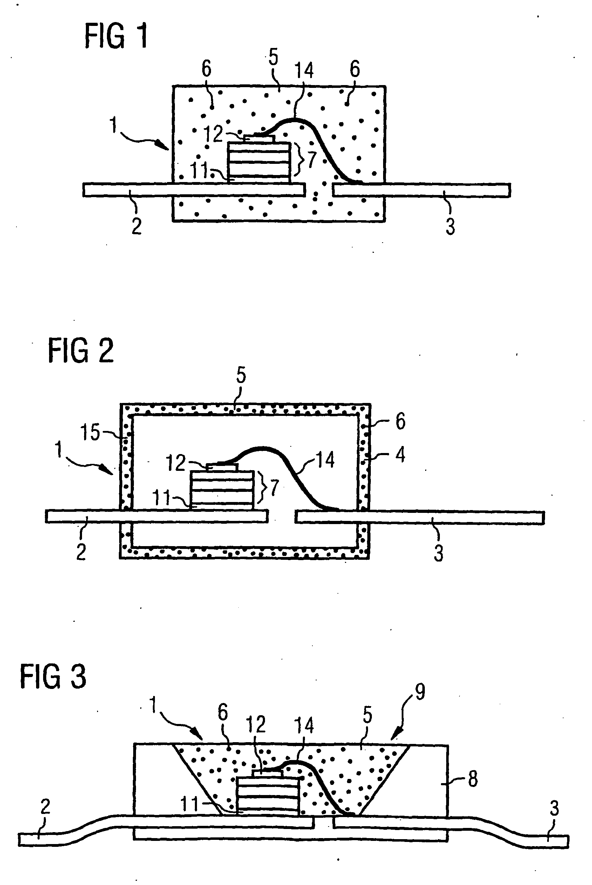

Bei dem in Figur 1 dargestellten optoelektronischen Bauelement ist ein Lumineszenzdiodenchip 1 mittels eines elektrisch leitenden Verbindungsmittels, zum Beispiel ein metallisches Lot oder ein Klebstoff, mit einem Rückseitenkontakt 11 auf einem ersten elektrischen Anschluss 2 eines Leiterrahmens befestigt. Auf einer dem Rückseitenkontakt 11 abgewandten Seite weist der Lumineszenzdiodenchip 1 einen Vorderseitenkontakt 12 auf, der mittels eines Bonddrahtes 14 mit einem zweiten elektrischen Anschluss 3 des Leiterrahmens elektrisch leitend verbunden ist.

Freie Oberflächen des Lumineszenzdiodenchip 1, der Bonddraht 14 sowie Teilbereiche der elektrischen Anschlüsse 2, 3 sind unmittelbar von einem Gehäusematerial 5 umschlossen, das für eine von dem Lumineszenzdiodenchip 1 bei dessen Betrieb emittierte elektromagnetische Strahlung durchlässig ist. Dieses Gehäusematerial 5 ist beispielsweise eine Vergussmasse, die mehr als 80 Gew-% Epoxidgießharz aufweist. Darüber hinaus kann die Vergussmasse noch Zusatzstoffe wie zum Beispiel Diethylenglykolmonomethylether, Tegopren 6875-45 und Aerosil 200 aufweisen.

Alternativ oder zusätzlich weist das Gehäusematerial 5 z.B. mindestens ein Hybridmaterial auf. Mit Hybridmaterialien ist es möglich, die positiven Eigenschaften verschiedener Materialien miteinander zu kombinieren. Dadurch können beispielsweise nachteilige Eigenschaften eines Materials abgeschwächt oder eliminert werden. Es wird z.B. ein Polymer-Hybridmaterial verwendet. Als Hybridmaterialien kommen z.B.

Silikon-modifizierte Epoxidharze in Frage, die bei Einwirkung von ultraviolettem Licht weniger stark altern als herkömmliche Epoxidharze, im Übrigen jedoch im Wesentlichen die positiven physikalischen Eigenschaften herkömmlicher Epoxidharze aufweisen. Es ist auch möglich, mindestens ein Epoxidharz und mindestens ein Silikon miteinander zu mischen. Beispiele für derartige geeignete Hybridmaterialien sind beispielsweise in der US 2002/0192477 A1 oder in der US 2005/0129957 A1 angegeben.

Es ist weiterhin möglich, Silikon mit Acrylat oder Silikon mit Acrylat und Epoxidharz zu kombinieren. Selbstverständlich ist es auch möglich, kein Hybridmaterial zu verwenden und beispielsweise ein Acrylat, ein Silikon oder ein Thermoplast als Bestandteil des Gehäusematerials 5 zu verwenden.

In die Vergussmasse 5 sind strahlungsabsorbierende Partikel 6 gemischt. Es handelt sich dabei zum Beispiel um einen industriell hergestellten Ruß mit definierten technischen Eigenschaften. Die Rußpartikel setzen sich aus einer Mehrzahl von Primärpartikeln zusammen, die gemeinsam eine Aggregatstruktur bilden. Diese Aggregatstruktur ist bevorzugt möglichst kompakt. Die Primärpartikel weisen einen mittleren Durchmesser von kleiner als oder gleich 100 nm auf. Beispielsweise beträgt der mittlere Durchmesser 50 bis 60 nm. Unter dem mittleren Durchmesser ist das Teilchenmittel der gemessenen Durchmesser zu verstehen. Die Aggregate weisen einen mittleren Durchmesser von kleiner als oder gleich 1 µm auf. Ein geeigneter Industrieruß ist beispielsweise das kommerziell erhältliche "Printex 25", das von dem Unternehmen Degussa hergestellt wird. Es handelt sich dabei um ein so genanntes "Low structure carbon black" (LSCB) mit kompakter Aggregatstruktur.

Die Partikelgröße der Primärpartikel und der Aggregate kann mit unterschiedlichen Methoden bestimmt werden. Beide Größen können beispielsweise mittels eines Transmissionselektronenmikroskops (TEM) bestimmt werden, was bevorzugt ist. Die Aggregatgröße kann beispielsweise auch mittels Streulicht-Intensitätsmessungen ermittelt werden. Für die Bestimmung der Primärteilchengröße eignen sich zum Beispiel auch differentielle Mobilitäts-Analysatoren (DMA), die üblicherweise benutzt werden, um den elektrischen Mobilitätsdurchmesser von nanoskaligen Aerosolen zu bestimmen. Derartige sowie weitere mögliche Meßmethoden zum Ermitteln der relevanten Partikeldurchmesser sind dem Fachmann bekannt.

Im Unterschied zu beispielsweise lang gestreckten Aggregatstrukturen haben kompakte Aggregatstrukturen den Vorteil, dass sie eine elektrische Leitfähigkeit des Materials, in das sie eingemischt sind, in geringerem Maße beeinflussen. Es gibt Untersuchungen, die zeigen, dass LSCB-Partikel erst bei einer viermal so hohen Volumenkonzentration als so genannte "High structure carbon black" (HSCB) einen Übergang von einem nicht leitenden zu einem leitenden Zustand des Matrixmaterials verursachen. Bei LSCB-Partikeln beginnt dieser Übergang beispielsweise ab einer Volumenkonzentration von zirka 40 Volumen-%, während dies bei HSCB-Partikeln bereits bei einer Konzentration von 10 Volumen-% der Fall sein kann. Das Vorhandensein von Salzen kann diesen Übergang zu niedrigeren Konzentrationen verschieben.

Oftmals bilden sich aus Rußaggregaten Agglomerate, die eine Größe in der Größenordnung von mehreren Mikrometern oder von mehreren 10µm aufweisen können. Derartige Agglomerate sollten möglichst vermieden werden. Beim Einmischen der Rußpartikel in die ungehärtete Vergussmasse werden diese mit Hilfe von Rotationsmixern, die bei sehr hohen Geschwindigkeiten betrieben werden, homogen eingearbeitet. Bei diesem Einarbeitungsprozess treten hohe Scherkräfte auf, die bewirken, dass etwaige Agglomerate zumindest zu einem Großteil aufgebrochen werden.

Die strahlungsabsorbierenden Partikel 6 werden beispielsweise mit einer Konzentration von maximal 0,01 Gew-% in die Vergussmasse gemischt, was etwa 0,03 Volumen-% entspricht.

Das in Figur 2 dargestellte Ausführungsbeispiel des Bauelements unterscheidet sich von dem vorhergehend anhand Figur 1 erläuterten Ausführungsbeispiel dadurch, dass der Lumineszenzdiodenchip 1, der Bonddraht 14 sowie Teilbereiche der elektrischen Anschlüsse 2 und 3 von einem transparenten inneren Gehäusematerial 15 umschlossen sind, das frei von strahlungsabsorbierenden Partikeln 6 ist. Dieses innere Gehäusematerial 15 besteht beispielsweise aus einem in der Leuchtdiodentechnik herkömmlich verwendeten Epoxid-, Silikon- oder Acrylatharz oder aus einem anderen geeigneten strahlungsdurchlässigen Material wie zum Beispiel anorganisches Glas.

Auf dieses innere Gehäusematerial 15 ist ein Gehäusematerial 5 aufgebracht, das mit strahlungsabsorbierenden Partikeln 6 versetzt ist. Dieses Gehäusematerial 5 liegt in Form einer Schicht 4 vor, die beispielsweise die gesamte Oberfläche des inneren Gehäusematerials 15 bedeckt. Ebenso denkbar ist, dass die Schicht 4 nur einen Teilbereich dieser Oberfläche bedeckt. Das Gehäusematerial 5 und die strahlungsabsorbierenden Partikel können wie vorhergehend im Zusammenhang mit dem in Figur 1 dargestellten Ausführungsbeispiel erläutert beschaffen sein.

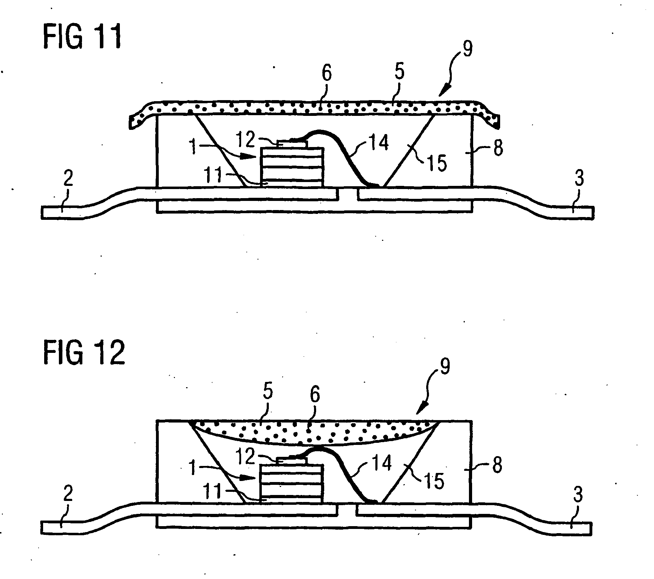

Alternativ zu dem in Figur 2 dargestellten Ausführungsbeispiel kann auch ein den Lumineszenzdiodechip 1 unmittelbar umkapselnder Teil des Gehäuses mit strahlungsabsorbierenden Partikeln 6 versetzt sein, auf dem wiederum ein transparentes Gehäusematerial aufgebracht sein kann, das frei von strahlungsabsorbierenden Partikeln ist. Eine derartige alternative Ausgestaltung ist beispielsweise auch bei dem nachfolgend anhand Figur 12 beschriebenen Ausführungsbeispiel möglich.

Das in Figur 3 dargestellte Ausführungsbeispiel des optoelektronischen Bauelements weist einen Gehäusegrundkörper 8 mit einer Ausnehmung 9 auf. Der Lumineszenzdiodenchip 1 ist in dieser Ausnehmung auf einem ersten elektrischen Anschluss 2 eines Leiterrahmens aufgebracht. Wie in den vorhergehend anhand der Figuren 1 und 2 erläuterten Ausführungsbeispielen ist ein Rückseitenkontakt 11 des Lumineszenzdiodenchips mit dem ersten elektrischen Anschluss 2 und ein Vorderseitenkontakt 12 mit dem zweiten elektrischen Anschluss 3 des Leiterrahmens elektrisch leitend verbunden.

Der Gehäusegrundkörper 8 ist beispielsweise mittels Spritzguss ausgebildet, was vor der Montage des Lumineszenzdiodenchips 1 erfolgen kann. Er besteht beispielsweise aus einem lichtundurchlässigen Kunststoff. Die Ausnehmung 9 ist hinsichtlich ihrer Form als ein Reflektor für die vom Lumineszenzdiodenchip 1 bei dessen Betrieb ausgesandte elektromagnetische Strahlung ausgebildet.

Die Ausnehmung 9 ist mit einem Gehäusematerial 5 gefüllt, das für eine von dem Bauelement emittierte Nutzstrahlung durchlässig ist. Es weist insbesondere homogen eingemischte strahlungsabsorbierende Partikel 6 auf. Das Gehäusematerial 5 und die strahlungsabsorbierenden Partikel 6 können wie bei den vorhergehend anhand der Figuren 1 und 2 beschriebenen Ausführungsbeispielen beschaffen sein.

Die vom Bauelement emittierte Nutzstrahlung ist beispielsweise ausschließlich eine von dem Lumineszenzdiodenchip 1 emittierte Strahlung. Alternativ ist es möglich, diese elektromagnetische Strahlung mittels mindestens eines Leuchtstoffes in eine Strahlung eines unterschiedlichen Wellenlängenbereiches zu konvertieren. Es ist insbesondere auch möglich, Leuchtstoffpartikel gemeinsam mit den strahlungsabsorbierenden Partikeln 6 in das für die Nutzstrahlung des Bauelements durchlässige Material 5 einzumischen. Wenn die Konzentration des Leuchtstoffes im Strahlengang der von dem Lumineszenzdiodenchip 1 emittierten elektromagnetischen Strahlung hoch genug ist, so kann diese Strahlung auch vollständig konvertiert werden.

Der Lumineszenzdiodenchip emittiert beispielsweise elektromagnetische Strahlung aus dem UV-Bereich. Diese wird beispielsweise mittels eines oder mehrerer Leuchtstoffe in sichtbares Licht konvertiert. Alternativ emittiert der Lumineszenzdiodenchip 1 beispielsweise blaues Licht. Dieses kann mittels eines Leuchtstoffes beispielsweise teilweise in gelbes Licht konvertiert werden, so dass durch eine Mischung des blauen und des gelben Lichtes bei einem ausgewogenen Mischungsverhältnis weißes Licht erzeugt werden kann.

Als Leuchtstoffe eignen sich grundsätzlich alle für die Anwendung bei LEDs bekannten Leuchtstoffe. Beispiele für derartige als Konverter geeignete Leuchtstoffe und Leuchtstoffmischungen sind:
- Chlorosilikate, wie beispielsweise in DE 10036940 und dem dort beschriebenen Stand der Technik offenbart,
- Orthosilikate; Sulfide, Thiometalle und Vanadate wie beispielsweise in WO 2000/33390 und dem dort beschriebenen Stand der Technik offenbart,
- Aluminate, Oxide, Halophosphate, wie beispielsweise in US 6616862 und dem dort beschriebenen Stand der Technik offenbart,
- Nitride, Sione und Sialone wie beispielsweise in DE 10147040 und dem dort beschriebenen Stand der Technik offenbart, und
- Granate der Seltenen Erden wie YAG:Ce und der Erdalkalielemente wie beispielsweise in US 2004-062699 und dem dort beschriebenen Stand der Technik offenbart.

Der Lumineszenzdiodenchip weist eine Halbleiterschichtenfolge 7 auf, die auf Nitrid-Verbindungshalbleitermaterialien basiert. Nitrid-Verbindungshalbleitermaterialien sind Verbindungshalbleitermaterialien, die Stickstoff enthalten, wie die Materialien aus dem System InₓAl_{y}Ga_{1-x-y}N mit 0 ≤ x ≤ 1, 0 ≤ y ≤ 1 und x+y ≤ 1. Unter die Gruppe von strahlungsemittierenden Lumineszenzdiodenchips auf Basis von Nitrid-Verbindungshalbleitermaterial fallen vorliegend insbesondere solche Lumineszenzdiodenchips, bei denen die Halbleiterschichtenfolge 7 mindestens eine Einzelschicht enthält, die ein Material aus dem Nitrid-Verbindungshalbleiter-material-System aufweist.

Die Halbleiterschicht kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert. Beispiele für solche MQW-Strukturen sind in den Druckschriften WO01/39282, US 6,172,382, US 5,831,277 und US 5, 684, 309 beschrieben.

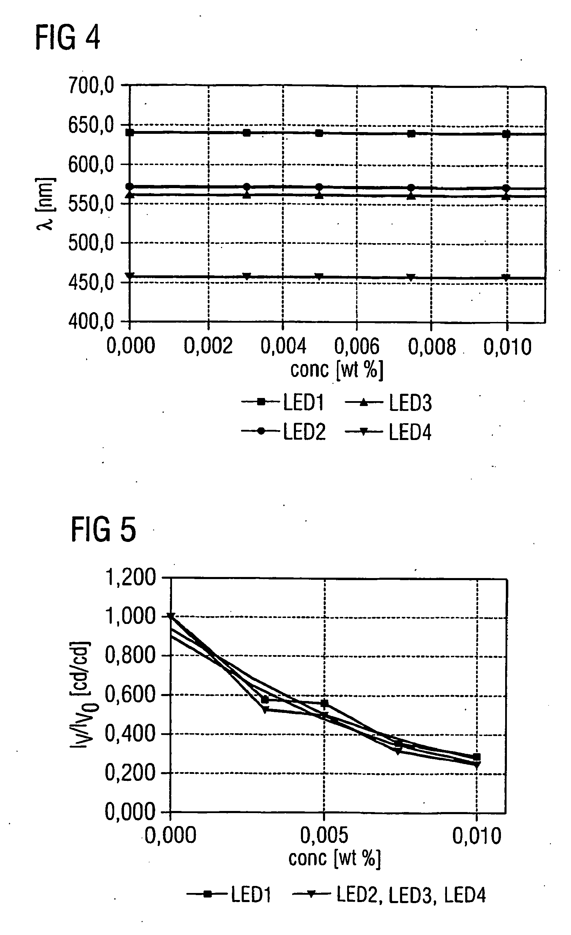

Die in den Figuren 4 bis 10 grafisch dargestellten Messergebnisse wurden mit Bauelementen erlangt, die in der Art des vorhergehend anhand Figur 3 erläuterten Bauelements beschaffen sind. Als strahlungsaborbierende Partikel wurde der Industrieruß Printex 25 des Unternehmens Degussa verwendet. Für die Messungen wurden gleiche Gehäuseformen vier verwendet, in die jedoch unterschiedliche Lumineszenzdiodenchips 1 mit unterschiedlichen Emissionsspektren montiert waren.

In Figur 4 sind die Wellenlängen der Emissionsmaxima für die vier Bauelementarten LED1, LED2, LED3, LED4 in Abhängigkeit von der Konzentration (conc) der strahlungsabsorbierenden Partikel angegeben. Die Wellenlänge ist in nm und die Konzentration in Gewichtsprozent (wt%) angegeben.

In Figur 4 ist zu erkennen, dass sich das Emissionsmaximum des Bauelements im Konzentrationsbereich zwischen 0 wt% und 0,01 wt% der strahlungsabsorbierenden Partikel nicht merkbar verändert. Der Lumineszenzdiodenchip des ersten Bauelements LED1 weist ein Emissionsmaximum bei etwa 640 nm auf, was rotem Licht entspricht. Das Emissionsmaximum des im zweiten Bauelement LED2 verwendeten Lumineszenzdiodenchips liegt bei etwa 570 nm, was einer gelblich grünen Farbe entspricht. Vom dritten optoelektronischen Bauelement LED3 wird grünes Licht mit einem Emissionsmaximum bei etwa 560 nm emittiert. Der Lumineszenzdiodenchip des vierten Bauelements LED4 emittiert blaues Licht mit einem Emissionsmaximum bei etwa 460 nm.

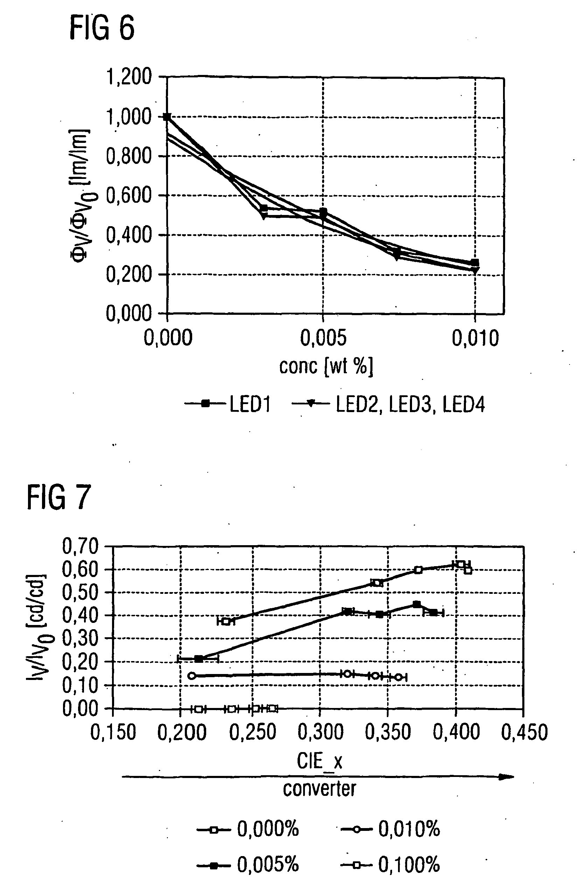

In Figur 5 ist die von den vier Bauelementarten emittierte Lichtstärke I_{V} in Abhängigkeit der Konzentration der strahlungsabsorbierenden Partikel dargestellt. Die Lichtstärke I_{V} ist jeweils auf die von dem Bauelement emittierte Lichtstärke I_{V0}, das keine strahlungsabsorbierenden Partikel aufweist (conc = 0 wt%), normiert. In Figur 6 ist in einer entsprechenden Auftragung der Lichtstrom Φ_{V} in Abhängigkeit der Konzentration der strahlungsabsorbierenden Partikel dargestellt.

Den in den Figuren 5 und 6 dargestellten Graphen ist zu entnehmen, dass sowohl die Lichtstärke I_{V} als auch der Lichtstrom Φ_{V} der Bauelementarten LED2, LED3 und LED4 etwa in gleicher Weise mit zunehmender Konzentration der absorbierenden Partikel abnimmt. Die Messpunkte für diese Bauelemente sind mit einem Dreieck symbolisiert, dessen Spitze nach unten gewandt ist. Demgegenüber zeigen die Messergebnisse für die erste Bauelementart LED1 leichte Abweichungen. Der grobe Verlauf der Abnahme von Lichtstärke I_{V} und Lichtstrom Φ_{V} mit zunehmender Konzentration der Absorberpartikel entspricht zwar demjenigen der zweiten bis vierten Bauelemente LED2, LED3, LED4. Allerdings nehmen Lichtstärke I_{V} und Lichtstrom Φ_{V} insgesamt für die erste Bauelementart LED1, die eine rot emittierende Lumineszenzdiode aufweist, etwas geringer ab.

Neben den Messpunkten, die mit geraden Linien miteinander verbunden sind, sind in den Figuren 5 und 6 jeweils zwei exponentielle Kurven dargestellt, die jeweils an die Messpunkte für die Bauelementart LED1 und für die Bauelementarten LED2 bis LED4 angepasst worden sind.

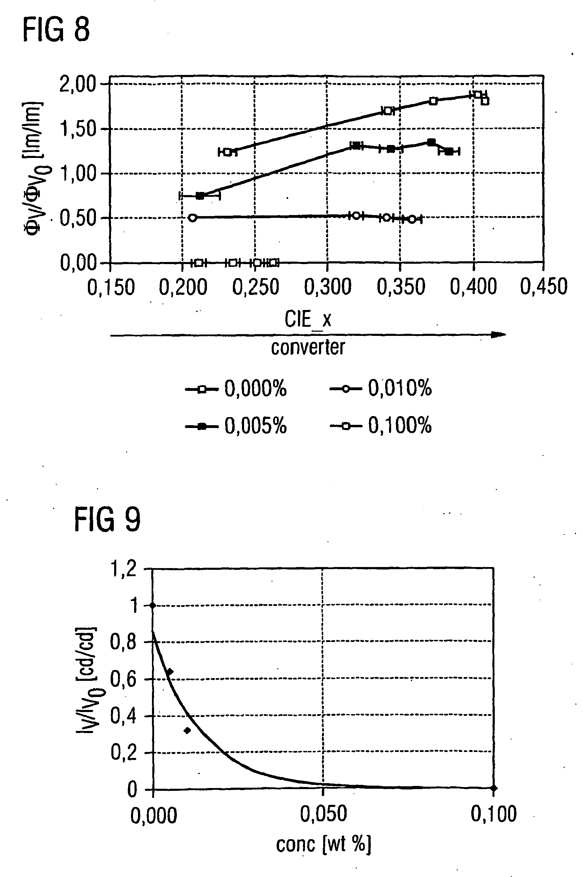

In den Figuren 7 und 8 sind Messungen der Lichtstärke I_{V} und des Lichtstromes Φ_{V} für die vierte Bauelementart LED4 (blau emittierender Lumineszenzdiodenchip) in Abhängigkeit des von dem Bauelement emittierten Farbortes dargestellt, wobei der Farbort durch den x-Wert der CIE-Farbtafel dargestellt ist. In den Figuren sind jeweils vier Messreihen eingezeichnet, die mit vier unterschiedlichen Konzentrationen der strahlungsabsorbierenden Partikel durchgeführt worden sind. In die Vergussmasse des Bauelements ist zudem ein gelber Leuchtstoff eingemischt, der durch blaues Licht anregbar ist. Es handelt sich hierbei um YAG:Ce, ein mit Ce aktivierter Yttriumaluminiumgranat.

Innerhalb einer Messreihe ist die Konzentration der Absorberpartikel konstant, wärend die Konzentration an Leuchtstoff variiert. In der Messreihe, in der die Konzentration an Absorberpartikel 0 wt% beträgt, ändert sich der CIE_x-Wert von etwa 0,23 mit zunehmendem Leuchtstoffgehalt auf etwa 0,41. Die zunehmende Leuchtstoffkonzentration ist in Figur 7 und Figur 8 unterhalb der Diagramme jeweils durch einen Pfeil angedeutet, der mit dem Ausdruck "converter" versehen ist. Im Vergleich mit den anderen Messreihen, in denen Absorberpartikel mit. Konzentrationen von 0,005 wt%, 0,01 wt% oder 0,1 wt% enthalten waren, lässt sich erkennen, dass sich sowohl die Untergrenze als auch die Obergrenze des CIE_x-Wertes, die bei ungefähr gleichen Leuchtstoffkonzentrationen gemessen wurden, jeweils zu kleineren Werten hin verschieben.

Bei CIE_x-Werten zwischen 0,2 und 0,25 weist das Mischlicht aus gelbem und blauem Licht im Ergebnis einen blau erscheinenden Farbton auf, während für CIE_x-Werte zwischen etwa 0,4 und 0,45 der gelbe Farbanteil überwiegt. Im Bereich zwischen 0,3 und 0,35 ergibt die Mischung von blauem und gelbem Licht insgesamt weißes Licht. Die Ergebnisse zeigen, dass bei Hinzufügen von Absorberpartikel zu dem Bauelement, in dessen Vergussmasse Leuchtstoffpartikel eingemischt sind, die Konzentration der Leuchtstoffpartikel erhöht werden muss, um eine Verschiebung des resultierenden vom Bauelement emittierten Farbeindrucks zu vermeiden.

Bei der Herstellung eines Bauelements mit Konvertermaterial kann somit zum Einstellen einer wohl definierten Lichtstärke zunächst die Konzentration der strahlungsabsorbierenden Partikel in Abhängigkeit der gemessenen Strahlstärke oder Lichtstärke des Lumineszenzdiodenchips gezielt ausgewählt werden. Zum gezielten Einstellen eines gewünschten Farbortes kann dann die Konzentration des Leuchtstoffs in Abhängigkeit der Konzentration der strahlungsabsorbierenden Partikel gezielt ausgewählt werden.

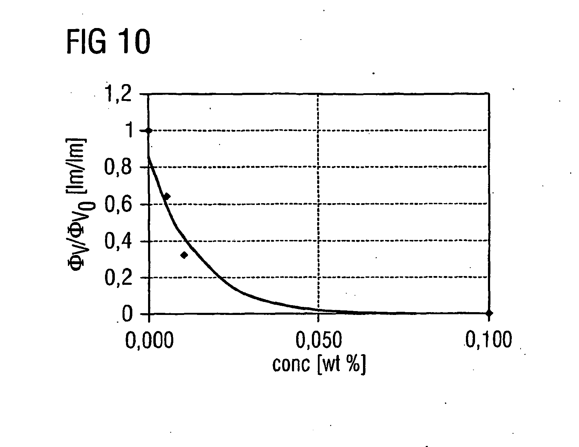

In den Figuren 9 und 10 sind Lichtstärke I_{V} und Lichtstrom Φ_{V} in Abhängigkeit der Konzentration der Absorberpartikel grafisch dargestellt. Es handelt sich wiederum um die vierte Bauelementart LED4, bei dem jeweils eine konstant bleibende Konzentration an Leuchtstoffpartikeln in die Vergussmasse eingemischt ist. Die Messergebnisse zeigen, dass sich auch bei Verwendung von Leuchtstoffen die Strahlstärke oder Lichtstärke von Bauelementen kontinuierlich einstellen lassen.

Die in den Figuren 11 und 12 dargestellten Bauelemente ähneln dem vorhergehend anhand Figur 3 beschriebenen Bauelement. Ein Unterschied ist, dass die Ausnehmung 9 des Gehäusegrundkörpers 8 jeweils mit einem Gehäusematerial 15 gefüllt ist, welches frei von strahlungsabsorbierenden Partikeln ist. Die Ausnehmung 9 ist beispielsweise derart mit dem Gehäusematerial 15 gefüllt, dass der in der Ausnehmung 9 montierte Lumineszenzdiodenchip 1 von dem Gehäusematerial 15 eingekapselt ist.

Bei den in den Figuren 11 und 12 dargestellten Bauelementen zubilden der Gehäusegrundkörper 8 und das Gehäusematerial 15 einen Gehäusekörper. Auf eine Außenfläche dieses Gehäusekörpers ist ein weiteres Gehäusematerial 5 aufgebracht, das für eine von dem Lumineszenzdiodenchip 1 bei dessen Betrieb emittierte elektromagnetische Strahlung durchlässig ist und das strahlungsabsorbierende Partikel 6 aufweist. Das Gehäusematerial 5 und die strahlungsabsorbierenden Partikel 6 können grundsätzlich so beschaffen sein, wie vorhergehend im Zusammenhang mit den übrigen Ausführungsbeispielen beschrieben ist.

Bei dem in Figur 11 dargestellten Bauelement ist das die strahlungsabsorbierenden Partikel 6 enthaltende Gehäusematerial 5 schichtförmig auf der Außenfläche des Gehäusekörpers 8, 15 aufgebracht. Bei der Herstellung des Bauelements kann das Gehäusematerial 5 in Form einer vorgefertigten Schicht mit beispielsweise konstanter Dicke bereitgestellt werden, bevor es auf die Außenfläche des Gehäusekörpers 8, 15 aufgebracht wird. Das Aufbringen erfolgt zum Beispiel mittels Kleben oder Auflaminieren. Es ist insbesondere möglich, das schichtförmige Gehäusematerial 5 als eine Folie bereitzustellen, die flexibel ist und die sich somit auch auf unebene Außenflächen des Gehäusekörpers aufbringen lässt. Nach dem Aufbringen kann die Folie beispielsweise gehärtet werden und ihre Flexibilität verlieren.

Ein Gehäusekörper 8, 15 mit einer unebenen Außenfläche ist beispielsweise in Figur 12 dargestellt. Auf diese lässt sich beispielsweise ein als Folie bereitgestelltes Gehäusematerial 5 mit strahlungsabsorbierenden Partikeln 6 aufbringen. Diese Möglichkeit ist jedoch nicht in Figur 12 dargestellt. Bei dem dargestellten Ausführungsbeispiel ist die Ausnehmung 9 nur teilweise mit dem Gehäusematerial 15 gefüllt. Die Außenfläche dieses Gehäusematerials 15 weist eine konkave Krümmung auf und bildet somit eine wannenartige oder beckenartige Vertiefung. In diese Vertiefung ist ein Gehäusematerial 5 eingefüllt, das strahlungsabsorbierende Partikel 6 aufweist. Das Auffüllen der Vertiefung erfolgt beispielsweise durch Bereitstellen des Gehäusematerials 5 in Form einer ungehärteten Masse, Vergießen der durch die Außenfläche des Gehäusematerials 15 gebildeten Vertiefung mit dieser Masse sowie durch nachfolgendes Aushärten des Gehäusematerials 5.

Bei dem in Figur 12 dargestellten Bauelement weist das Gehäusematerial 5 eine schichtartige Form auf, die jedoch keine konstante Dicke aufweist. Im Bereich der optischen Achse des Bauelements weist das Gehäusematerial 5 beispielsweise eine größte Dicke auf, die mit größer werdendem Abstand zur optischen Achse des Bauelements zunehmend kleiner wird. Durch derartige Gehäusematerialschichten 5 mit variierender Dicke lässt sich nicht nur eine vom Bauelement emittierte Lichtintensität oder Strahlungsintensität, sondern auch eine Abstrahlcharakteristik des Bauelements gezielt einstellen. Die Variation der Dicke des Gehäusematerials 5 kann selbstverständlich grundsätzlich beliebig sein und ist auf das im Einzelfall vorliegende Bauelement und die zu erzielende Abstrahlcharakteristik abgestimmt.

Es ist Alternativ zu dem in Figur 12 dargestellten Beispiel auch möglich, dass die Gehäusematerialschicht 5 in Außenbereichen eine größere Dicke aufweist als in der Mitte.

Weiterhin ist es bei den anhand der Figuren 11 und 12 beschriebenen Ausführungsbeispielen auch möglich, dass das optoelektronische Bauelement frei von einem Gehäusegrundkörper 8 ist. Dies kann beispielsweise mit einer Ausgestaltung des Gehäuses in der Art wie bei den vorhergehend anhand der Figuren 1 und 2 beschriebenen Bauelementen realisiert werden.

Bei allen Ausführungsbeispielen ist es z.B. zusätzlich oder alternativ zu der Verwendung eines mit strahlungsabsorbierenden Partikeln 6 versetzten Gehäusematerials auch möglich, dass der Lumineszenzdiodenchip mit einer Folie versehen ist, die mit strahlungsabsorbierenden Partikeln versetzt ist. Die Folie weist beispielsweise ein Silikon oder ein Hybridmaterial mit einem Epoxidharz auf. Die strahlungsabsorbierenden Partikel können wie vorhergehend bereits beschrieben beschaffen sein.

Die Erfindung ist nicht durch die Beschreibung der Erfindung anhand der Ausführungsbeispiele auf diese beschränkt.

Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist. Neben Ruß gibt es eine Vielzahl weiterer Materialien, die nicht Gegenstand der Erfindung sind, die grundsätzlich für die Verwendung als strahlungsabsorbierende Partikel in dem Bauelement geeignet sind. Die Eignung der Materialien kann von dem Emissionsspektrum der von dem Bauelement emittierten Nutzstrahlung abhängen.

## Patentansprüche

1. Optoelektronisches Bauelement, das eine Nutzstrahlung emittiert, mit einem Gehäuse und einem in dem Gehäuse angeordneten Lumineszenzdiodenchip (1),
wobei das Gehäuse ein für die Nutzstrahlung durchlässiges Gehäusematerial (5) aufweist, das zum Einstellen einer vorgegebenen Strahlstärke oder Lichtstärke der emittierten Nutzstrahlung gezielt mit strahlungsabsorbierenden Partikeln (6) versetzt ist, **dadurch gekennzeichnet, dass** die strahlungsabsorbierenden Partikel (6) Ruß aufweisen.

2. Optoelektronisches Bauelement gemäß Anspruch 1,
**dadurch gekennzeichnet, dass**
die strahlungsabsorbierenden Partikel (6) für das gesamte Wellenlängenspektrum der Nutzstrahlung absorbierend sind.

3. Optoelektronisches Bauelement gemäß einem der vorhergehenden Patentansprüche,
**dadurch gekennzeichnet, dass**
die strahlungsabsorbierenden Partikel (6) für das gesamte Wellenlängenspektrum der von dem Lumineszenzdiodenchip (1) bei dessen Betrieb emittierten Strahlung absorbierend sind.

4. Optoelektronisches Bauelement gemäß einem der vorhergehenden Patentansprüche,
**dadurch gekennzeichnet, dass**
das für die Nutzstrahlung durchlässige Gehäusematerial (5) eine Gussmasse oder Pressmasse aufweist.

5. Optoelektronisches Bauelement gemäß einem der vorhergehenden Patentansprüche,
**dadurch gekennzeichnet, dass**
das für die Nutzstrahlung durchlässige Gehäusematerial (5) mindestens eines der Materialien aus der Gruppe bestehend aus Epoxidharz, Acrylat, Silikon, Thermoplast und Hybridmaterial mit mindestens einem dieser Materialien aufweist.

6. Optoelektronisches Bauelement gemäß einem der vorhergehenden Patentansprüche,
**dadurch gekennzeichnet, dass**
der Lumineszenzdiodenchip (1) mittels des für die Nutzstrahlung durchlässigen Gehäusematerials (5) umkapselt oder umformt ist.

7. Optoelektronisches Bauelement gemäß einem der vorhergehenden Patentansprüche,
**dadurch gekennzeichnet, dass**
das für die Nutzstrahlung durchlässige Gehäusematerial (5) mindestens einen Leuchtstoff aufweist.

8. Optoelektronisches Bauelement gemäß einem der vorhergehenden Ansprüche,
**dadurch gekennzeichnet, dass**
der Ruß ein Industrieruß mit kompakter Aggregatstruktur der unter der Bezeichnung LSCB, d.h. "low structure carbon black" , bekannt ist.

9. Optoelektronisches Bauelement gemäß einem der vorhergehenden Patentansprüche,
**dadurch gekennzeichnet, dass**
die strahlungsabsorbierenden Partikel (6) einen durchschnittlichen Partikeldurchmesser von kleiner als oder gleich 100 nm aufweisen.

10. Optoelektronisches Bauelement gemäß einem der vorhergehenden Patentansprüche,
**dadurch gekennzeichnet, dass**
der Absorptionskoeffizient der strahlungsabsorbierenden Partikel (6) im gesamten Spektrum der Nutzstrahlung um weniger als 10 % variiert.

11. Optoelektronisches Bauelement gemäß einem der vorhergehenden Patentansprüche,
**dadurch gekennzeichnet, dass**
das Bauelement einen Gehäusegrundkörper (8) mit einer Gehäusekavität (9) aufweist, in der der Lumineszenzdiodenchip (1) montiert ist und die zumindest teilweise mit dem für die Nutzstrahlung durchlässigen Gehäusematerial (5) gefüllt ist.

12. Optoelektronisches Bauelement gemäß einem der vorhergehenden Patentansprüche,
**dadurch gekennzeichnet, dass**
das Bauelement einen Gehäusekörper (8) aufweist und das für die Nutzstrahlung durchlässige Gehäusematerial (5) auf einer Außenfläche des Gehäusekörpers (8) aufgebracht ist.

13. Optoelektronisches Bauelement gemäß Patentanspruch 12,
**dadurch gekennzeichnet, dass**
das für die Nutzstrahlung durchlässige Gehäusematerial (5) in Form einer Folie auf der Außenfläche des Gehäusekörpers (8) aufgebracht ist.

14. Verfahren zum Herstellen eines eine Nutzstrahlung emittierenden optoelektronischen Bauelements, mit den Schritten:
- Bereitstellen eines Lumineszenzdiodenchips (1),
- Messen der vom Lumineszenzdiodenchip (1) emittierten Strahlstärke oder Lichtstärke,
- Bereitstellen einer für die Nutzstrahlung durchlässigen Masse (5), die mit strahlungsabsorbierenden Partikeln (6) versetzt ist, wobei die strahlungsabsorbierenden Partikel (6) Ruß aufweisen,
- gezieltes Auswählen einer Konzentration der strahlungsabsorbierenden Partikel in der Masse (5) in Abhängigkeit der gemessenen Strahlstärke oder Lichtstärke des Lumineszenzdiodenchips (1), zum Einstellen einer zu erzielenden Strahlstärke oder Lichtstärke des Bauelements,
- Anordnen der für die Nutzstrahlung durchlässigen Masse (5) in einem Strahlengang der von dem Lumineszenzdiodenchip (1) bei dessen Betrieb emittierten elektromagnetischen Strahlung.

15. Verfahren gemäß Anspruch 14,
bei dem der Lumineszenzdiodenchip (1) mit der für die Nutzstrahlung durchlässigen Masse (5) umkapselt oder umformt wird.

16. Verfahren gemäß Anspruch 14 oder 15, bei dem eine für die Nutzstrahlung durchlässige Masse (5) bereitgestellt wird, die neben den strahlungsabsorbierenden Partikeln (6) auch mindestens einen Leuchtstoff aufweist,
und bei dem die Konzentration des Leuchtstoffs in der Masse (5) in Abhängigkeit der ausgewählten Konzentration der strählungsabsorbierenden Partikel (6) gezielt ausgewählt wird, zum Einstellen eines zu erzielenden Farbortes der vom Bauelement zu emittierenden Nutzstrahlung.

17. Verfahren gemäß einem der Ansprüche 14 bis 16, mit den weiteren Verfahrensschritten:
- Bereitstellen eines Gehäusegrundkörpers (8) mit einer Gehäusekavität (9),
- Montieren des Lumineszenzdiodenchips (1) in der Gehäusekavität (9),
- zumindest teilweises Vergießen der Gehäusekavität (9) mit der für die Nutzstrahlung durchlässigen Masse (5).

18. Verfahren gemäß einem der Ansprüche 14 bis 16,
bei dem ein Bauelement bereitgestellt wird, das den Lumineszenzdiodenchip (1) enthält und das einen Gehäusekörper (8) mit einer Außenfläche aufweist, wobei die für die Nutzstrahlung durchlässige Masse (5) auf die Außenfläche des Gehäusekörpers (8) aufgebracht wird.

19. Verfahren gemäß Anspruch 18,
bei dem die für die Nutzstrahlung durchlässige Masse (5) vor dem Aufbringen auf der Außenfläche in Form einer vorgefertigten Materialschicht bereitgestellt wird.

20. Verfahren gemäß Anspruch 18 oder 19,
bei dem die für die Nutzstrahlung durchlässige Masse (5) vor dem Aufbringen auf der Außenfläche in Form einer Folie bereitgestellt wird.

## Claims

1. Optoelectronic component which emits a useful radiation, comprising a housing and a luminescence diode chip (1) arranged in the housing,
the housing having a housing material (5) which is transmissive to the useful radiation and which is admixed with radiation-absorbing particles (6) in a targeted manner for setting a predetermined radiant intensity or luminous intensity of the emitted useful radiation,
**characterized in that**
the radiation-absorbing particles (6) have carbon black.

2. Optoelectronic component according to Claim 1,
**characterized in that**
the radiation-absorbing particles (6) are absorbent for the entire wavelength spectrum of the useful radiation.

3. Optoelectronic component according to one of the preceding patent claims,
**characterized in that**
the radiation-absorbing particles (6) are absorbent for the entire wavelength spectrum of the radiation emitted by the luminescence diode chip (1) during the operation thereof.

4. Optoelectronic component according to one of the preceding patent claims,
**characterized in that**
the housing material (5) which is transmissive to the useful radiation has a casting composition or moulding composition.

5. Optoelectronic component according to one of the preceding patent claims,
**characterized in that**
the housing material (5) which is transmissive to the useful radiation has at least one of the materials from the group comprising epoxy resin, acrylate, silicone, thermoplastic and hybrid material with at least one of said materials.

6. Optoelectronic component according to one of the preceding patent claims,
**characterized in that**
the luminescence diode chip (1) is encapsulated or surrounded by moulding by means of the housing material (5) which is transmissive to the useful radiation.

7. Optoelectronic component according to one of the preceding patent claims,
**characterized in that**
the housing material (5) which is transmissive to the useful radiation has at least one phosphor.

8. Optoelectronic component according to one of the preceding claims,
**characterized in that**
the carbon black is an industrial carbon black with a compact aggregate structure known under the designation LSCB, i.e. "low structure carbon black".

9. Optoelectronic component according to one of the preceding patent claims,
**characterized in that**
the radiation-absorbing particles (6) have an average particle diameter of less than or equal to 100 nm.

10. Optoelectronic component according to one of the preceding patent claims,
**characterized in that**
the absorption coefficient of the radiation-absorbing particles (6) varies by less than 10% in the entire spectrum of the useful radiation.

11. Optoelectronic component according to one of the preceding patent claims,
**characterized in that**
the component has a housing basic body (8) with a housing cavity (9) in which the luminescence diode chip (1) is mounted and which is at least partly filled with the housing material (5) which is transmissive to the useful radiation.

12. Optoelectronic component according to one of the preceding patent claims,
**characterized in that**
the component has a housing body (8) and the housing material (5) which is transmissive to the useful radiation is applied on an exterior area of the housing body (8).

13. Optoelectronic component according to Patent Claim 12,
**characterized in that**
the housing material (5) which is transmissive to the useful radiation is applied in the form of a film on the exterior area of the housing body (8).

14. Method for producing an optoelectronic component which emits a useful radiation, comprising the steps of:
- providing a luminescence diode chip (1),
- measuring the radiant intensity or luminous intensity emitted by the luminescence diode chip (1),
- providing a composition (5) which is transmissive to the useful radiation and which is admixed with radiation-absorbing particles (6), the radiation-absorbing particles (6) having carbon black
- selecting in a targeted manner a concentration of the radiation-absorbing particles in the composition (5) depending on the measured radiant intensity or luminous intensity of the luminescence diode chip (1), for setting a radiant intensity or luminous intensity to be obtained in the component,
- arranging the composition (5) which is transmissive to the useful radiation in a beam path of the electromagnetic radiation emitted by the luminescence diode chip (1) during the operation thereof.

15. Method according to Claim 14,
in which the luminescence diode chip (1) is encapsulated or surrounded by moulding with the composition (5) which is transmissive to the useful radiation.

16. Method according to Claim 14 or 15, in which a composition (5) which is transmissive to the useful radiation and which also has at least one phosphor besides the radiation-absorbing particles (6) is provided,
and in which the concentration of the phosphor in the composition (5) is selected in a targeted manner depending on the selected concentration of the radiation-absorbing particles (6), for setting a colour locus to be obtained of the useful radiation to be emitted by the component.

17. Method according to one of Claims 14 to 16, comprising the further method steps of:
- providing a housing basic body (8) having a housing cavity (9),
- mounting the luminescence diode chip (1) in the housing cavity (9),
- at least partly potting the housing cavity (9) with the composition (5) which is transmissive to the useful radiation.

18. Method according to one of Claims 14 to 16,
in which a component is provided which contains the luminescence diode chip (1) and which has a housing body (8) having an exterior area, the composition (5) which is transmissive to the useful radiation being applied to the exterior area of the housing body (8).

19. Method according to Claim 18,
in which the composition (5) which is transmissive to the useful radiation is provided prior to application on the exterior area in the form of a prefabricated material layer.

20. Method according to Claim 18 or 19,
in which the composition (5) which is transmissive to the useful radiation is provided prior to application on the exterior area in the form of a film.

## Revendications

1. Composant optoélectronique émettant un rayonnement utile, avec un boîtier et une puce de diode luminescente (1) disposée dans le boîtier,
dans lequel le boîtier comporte un matériau (5) du boîtier, transparent au rayonnement utile, qui est additionné de manière ciblée de particules (6) absorbant le rayonnement pour régler une intensité de rayonnement ou une intensité lumineuse définie du rayonnement utile émis,
**caractérisé en ce que** les particules (6) absorbant le rayonnement comportent du noir.

2. Composant optoélectronique selon la revendication 1,
**caractérisé en ce que** les particules (6) absorbant le rayonnement sont absorbantes pour l'ensemble du spectre des longueurs d'ondes du rayonnement utile.

3. Composant optoélectronique selon une des revendications précédentes,
**caractérisé en ce que** les particules (6) absorbant le rayonnement sont absorbantes pour l'ensemble du spectre des longueurs d'ondes du rayonnement émis par la puce de diode luminescente (1) lors de son fonctionnement.

4. Composant optoélectronique selon une des revendications précédentes,
**caractérisé en ce que** le matériau (5) du boîtier, transparent au rayonnement utile, comporte une matière moulée ou une matière pressée.

5. Composant optoélectronique selon une des revendications précédentes,
**caractérisé en ce que** le matériau (5) du boîtier, transparent au rayonnement utile, comporte au moins un des matériaux du groupe constitué de résine époxy, d'acrylate, de silicone, de thermoplastique et de matériau hybride avec au moins un de ces matériaux.

6. Composant optoélectronique selon une des revendications précédentes,
**caractérisé en ce que** la puce de diode luminescente (1) est encapsulée ou façonnée au moyen du matériau (5) du boîtier, transparent au rayonnement utile.

7. Composant optoélectronique selon une des revendications précédentes,
**caractérisé en ce que** le matériau (5) du boîtier, transparent au rayonnement utile, comporte au moins une substance luminescente.

8. Composant optoélectronique selon une des revendications précédentes,
**caractérisé en ce que** le noir est un noir industriel avec une structure compacte d'agrégats connu sous la désignation LSCB c'est-à-dire "Low Structure Carbon Black".

9. Composant optoélectronique selon une des revendications précédentes,
**caractérisé en ce que** les particules (6) absorbant le rayonnement comportent un diamètre moyen de particules inférieur ou égal à 100 nm.

10. Composant optoélectronique selon une des revendications précédentes,
**caractérisé en ce que** le coefficient d'absorption des particules (6) absorbant le rayonnement varie de moins de 10% sur l'ensemble du spectre du rayonnement utile.

11. Composant optoélectronique selon une des revendications précédentes,
**caractérisé en ce que** le composant comporte un corps de la base du boîtier (8) avec une cavité du boîtier (9), dans laquelle la puce de diode luminescente (1) est montée et qui est remplie au moins partiellement par le matériau (5) du boîtier, transparent au rayonnement utile.

12. Composant optoélectronique selon une des revendications précédentes,
**caractérisé en ce que** le composant comporte un corps de boîtier (8) et que le matériau (5) du boîtier, transparent au rayonnement utile, est appliqué sur une surface extérieure du corps de boîtier (8).

13. Composant optoélectronique selon la revendication 12,
**caractérisé en ce que** le matériau (5) du boîtier, transparent au rayonnement utile, est appliqué sur la surface extérieure du corps de boîtier (8) sous la forme d'une feuille.

14. Procédé pour la fabrication d'un composant optoélectronique émettant un rayonnement utile, avec les étapes suivantes :
- préparation d'une puce de diode luminescente (1),
- mesure de l'intensité de rayonnement ou l'intensité lumineuse émise par la puce de diode luminescente (1),
- préparation d'une matière (5) transparente au rayonnement utile, qui est additionnée de particules (6) absorbant le rayonnement, les particules (6) absorbant le rayonnement comportant du noir,
- choix ciblé d'une concentration des particules absorbant le rayonnement dans la matière (5) en fonction de la mesure de l'intensité de rayonnement ou l'intensité lumineuse de la puce de diode luminescente (1), pour régler une intensité de rayonnement ou une intensité lumineuse du composant à atteindre,
- disposition de la matière (5) transparente au rayonnement utile sur un chemin optique du rayonnement électromagnétique émis par la puce de diode luminescente (1) lors de son fonctionnement.

15. Procédé selon la revendication 14,
dans lequel la puce de diode luminescente (1) est encapsulée ou façonnée avec la matière (5) transparente au rayonnement utile.

16. Procédé selon la revendication 14 ou 15,
dans lequel on prépare une matière (5) transparente au rayonnement utile qui en plus des particules (6) absorbant le rayonnement, comporte également au moins une substance luminescente,
et dans lequel la concentration de la substance luminescente dans la matière (5) est choisie de manière ciblée en fonction de la concentration choisie des particules (6) absorbant le rayonnement, pour régler un domaine de couleur à atteindre par le rayonnement utile devant être émis par le composant.

17. Procédé selon une des revendications 14 à 16, avec les étapes supplémentaires suivantes :
- préparation d'un corps de la base du boîtier (8) avec une cavité du boîtier (9),
- montage de la puce de diode luminescente (1) dans la cavité du boîtier (9),
- remplissage au moins partiel de la cavité du boîtier (9) par la matière (5) transparente au rayonnement utile.

18. Procédé selon une des revendications 14 à 16,
dans lequel on prépare un composant contenant la puce de diode luminescente (1), et qui comporte un corps de boîtier (8) avec une surface extérieure, la matière (5) transparente au rayonnement utile étant appliquée sur la surface extérieure du corps de boîtier (8).

19. Procédé selon la revendication 18,
dans lequel on prépare la matière (5) transparente au rayonnement utile avant l'application sur la surface extérieure sous la forme d'une couche de matériau préfabriquée.

20. Procédé selon la revendication 18 ou 19,
dans lequel on prépare la matière (5) transparente au rayonnement utile avant l'application sur la surface extérieure sous la forme d'une feuille.
